# EUROPEAN PATENT APPLICATION

(11) **EP 4 600 999 A1**
(43) Date of publication of application: **13.08.2025**
(21) Application number: 24156080.4
(22) Date of filing: 06.02.2024
(51) Int. Cl.: H01L 23/31, H01L 23/495, H01L 23/367, H01L 23/492

(54) **A SEMICONDUCTOR PACKAGE COMPRISING AN ELECTRICAL CONTACT MEMBER FOR DOWN-CONNECTING A CONTACT PAD WITH A SUBSTRATE**

(71) Applicant: Infineon Technologies Austria AG, 9500 Villach (AT)
(72) Inventor: OTREMBA, Ralf, 87600 Kaufbeuren (DE)
(74) Representative: Lambsdorff & Lange Patentanwälte Partnerschaft mbB

(57) **Abstract**

A semiconductor device package (20; 30) comprising a semiconductor transistor die comprising a first main face, a second main face opposite to the first main face, a first contact pad (11B) disposed on the first main face, and a second contact pad (11A) disposed on the second main face, an encapsulant (12) embedding the semiconductor transistor die, the encapsulant (12) comprises a first main face and a second main face opposite to the first main face, wherein the second main face of the encapsulant (12) is coplanar with the second main face of the semiconductor transistor die (11), and an electrical contact member (15; 25) connected with the encapsulant (12), the electrical contact member (15; 25) comprising a first horizontal portion (15A; 25A) and side portions (15B; 25B) connected to opposite side edges of the first horizontal portion (15A; 25A), wherein the first horizontal portion (15A; 25A) is connected with the second main face of the encapsulant (12); and wherein the side portions (15B; 25B) extend along first opposing side faces of the encapsulant (12) and are configured as first electrical contact elements.

## Description

### TECHNICAL FIELD

The present disclosure is related to a semiconductor package and a semiconductor module comprising the semiconductor package.

### BACKGROUND

Power semiconductor packages include a power semiconductor die, in particular a power semiconductor transistor die, embedded in a mold compound. The contact pads of the semiconductor transistor die like, for example, the source pad and the drain pad, are connected with external contact elements which allow the package to be mounted onto a substrate, like a printed circuit board (PCB). Due to the high currents of up to 10A and higher flowing in the load path of the semiconductor transistor, excessive heat is generated which has to be efficiently dissipated. Conducting the high electrical currents and simultaneously dissipating the excess heat requires the provision of an improved concept regarding the routing of the electrical connections.

For these and other reasons there is a need for the present disclosure.

### SUMMARY

A first aspect of the present disclosure is related to a semiconductor device package comprising a semiconductor transistor die comprising a first main face, a second main face opposite to the first main face, a first contact pad disposed on the first main face, and a second contact pad disposed on the second main face, an encapsulant embedding the semiconductor transistor die, the encapsulant comprises a first main face and a second main face opposite to the first main face, wherein the second main face of the encapsulant is coplanar with the second main face of the semiconductor transistor die, and an electrical contact member connected with the encapsulant, the electrical contact member comprising a first horizontal portion and side portions, side portions connected to opposite side edges of the first horizontal portion, wherein the first horizontal portion is connected with the second main face of the encapsulant, and wherein the side portions extend along first opposing side faces of the encapsulant and are configured as first electrical contact elements.

According to an embodiment of the semiconductor package of the first aspect, the side portions of the electrical contact member each comprise a vertical portion connected with the first horizontal portion and second horizontal portions connected with the vertical portions, wherein outer surfaces of the second horizontal portions are coplanar with the first main face of the encapsulant.

According to an embodiment of the semiconductor package of the first aspect, the side portions of the electrical contact member each comprise a vertical portion connected with the horizontal portion wherein the vertical portions extend beyond the first main face of the encapsulant.

According to an embodiment of the semiconductor package of the first aspect, one or more side portions are connected to the opposite side edges of the first horizontal portion.

According to an embodiment of the semiconductor package of the first aspect, the package further comprises second electrical contact elements connected with the first contact pad of the semiconductor transistor die. According to an example thereof, the second electrical contact elements are partly embedded within the encapsulant and extend through at least one second side face of the encapsulant which is oriented perpendicular to the first side faces of the encapsulant. According to a further example thereof, the second electrical contact elements extend through two opposing side faces which are both perpendicular to the first opposing side faces of the encapsulant.

According to an embodiment of the semiconductor device of the first aspect, the semiconductor transistor die comprises one or more of a vertical semiconductor transistor die, a semiconductor power transistor die, an IGBT die, a MOSFET die, a CoolMOS die, a wide band gap semiconductor transistor die, in particular a SiC transistor die or a GaN transistor die.

According to an embodiment of the semiconductor device of the first aspect, the first contact pad of the semiconductor transistor die is a source/emitter contact pad and the second contact pad is drain/collector contact pad.

According to an embodiment of the semiconductor device of the first aspect, the horizontal portion of the electrical contact member is connected to the second main face of the encapsulant by means of a solder layer, a sinter layer, or an adhesive layer.

A second aspect of the present disclosure is related to a semiconductor device, comprising a substrate, and a semiconductor package according to the first aspect mounted on the substrate.

According to an embodiment of the semiconductor device of the second aspect, the substrate comprises electrical contact areas, wherein the second horizontal portions of the electrical contact member are connected with the electrical contact areas of the substrate.

According to an embodiment of the semiconductor device of the second aspect, the substrate comprises through-holes, wherein lower ends of the vertical portions of the electrical contact member are put through the through holes of the substrate.

According to an embodiment of the semiconductor device of the second aspect, the substrate comprises a printed circuit board.

According to an embodiment of the semiconductor device of the second aspect, the device further comprises a heatsink mounted onto the surface of the first horizontal portion of the electrical contact member of the semiconductor package.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 comprises Fig. 1A and 1B and shows a perspective view on a semiconductor package with an exposed upper contact pad of a semiconductor die (A) and an electrical contact member provided to be connected with the contact pad (B) .
Fig. 2 comprises Fig. 2A and 2B and shows a semiconductor package to be mounted by surface mounting technique (A) and a semiconductor package to be mounted by trough-hole technique.
Fig. 3 comprises Fig. 3A and 3B and shows the semiconductor package of Fig. 2A mounted on a substrate (A) and the semiconductor package of Fig. 2B mounted on a substrate (B) .

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the word "over" used with regard to a part, element or material layer formed or located "over" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the word "over" used with regard to a part, element or material layer formed or located "over" a surface may, optionally, also have the specific meaning that the part, element or material layer be located (e.g. placed, formed, deposited, etc.) "directly on", e.g. in direct contact with, the implied surface.

### DETAILED DESCRIPTION

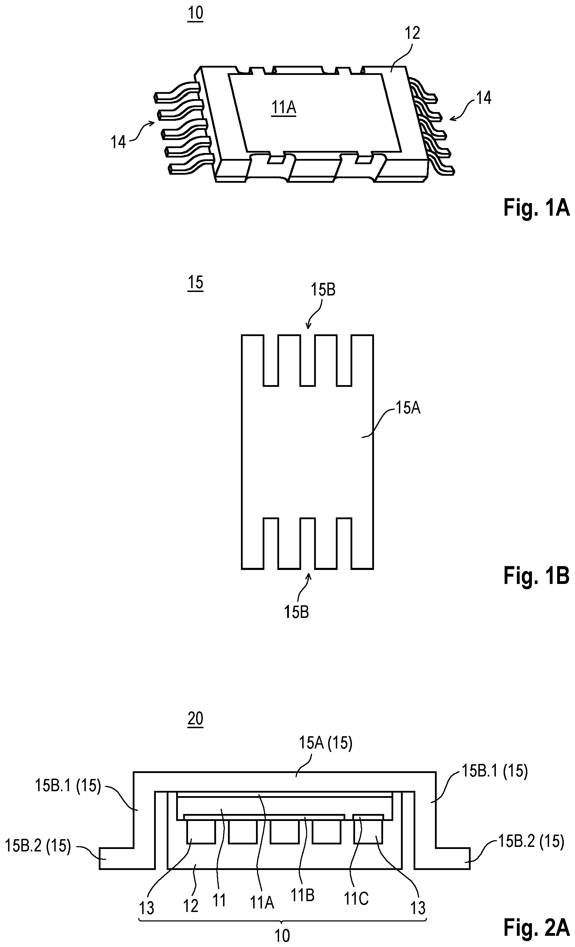

Fig. 1 comprises Fig. 1A and 1B and shows a perspective view on a semiconductor package with an exposed upper contact pad of a semiconductor die (A) and an electrical contact member provided to be connected with the contact pad (B) .

The semiconductor package 10 shown in Fig. 1A comprises a semiconductor die, of which only the outwardly exposed contact pad 11A on an upper first main face of the semiconductor die is visible. The contact pad 11A can be, for example, the drain pad. Otherwise the semiconductor die is embedded in an encapsulant 12 so that a source pad and a gate pad, both disposed on a second lower main face of the semiconductor die, is covered by the encapsulant 12. The source pad and the gate pad are electrically connected with a plurality of pins 14 which extend through opposing side faces of the encapsulant. In the example shown in Fig. 1, the pins 14 comprise horizontal outer ends so that they are configured to be connected with a PCB according to the surface-mounting technique. However, it is also possible that the outer ends of the pins are vertically formed so that they are configured to be connected to a PCB according to the through-hole technique.

The semiconductor die may comprise one or more of a vertical semiconductor transistor die, a semiconductor power transistor die, an IGBT die, a MOSFET die, a CoolMOS die, a wide band gap semiconductor transistor die, in particular a SiC transistor die or a GaN transistor die.

The encapsulant 12 may be comprised of a conventional mold compound like, for example, a resin material, in particular an epoxy resin material. Moreover, the encapsulant 12 can be made of a thermally conductive material to allow efficient heat dissipation to external application heat sinks. The material of the encapsulant 12 can, in particular, comprise a resin like an epoxy resin material filled with particles like, for example, SiO or other ceramic particles, or thermally conductive particles like, for examples, Al₂O₃, BN, AlN, Si₃N₄, diamond, or any other thermally conductive particles in order to increase the thermal conductivity of the encapsulant 12.

The electrical contact member 15 shown in Fig. 1B comprises a sheet of a metal as, for example, copper. The electrical contact member 15 comprises a central portion 15A and opposing side portions 15B connected with opposing edges of the central portion 15A. The example shown in Fig. 1B shows 4 side portions on each side of the central portion 15A. However, also any other integer number of side portions is possible, even only one side portion on each side is conceivable.

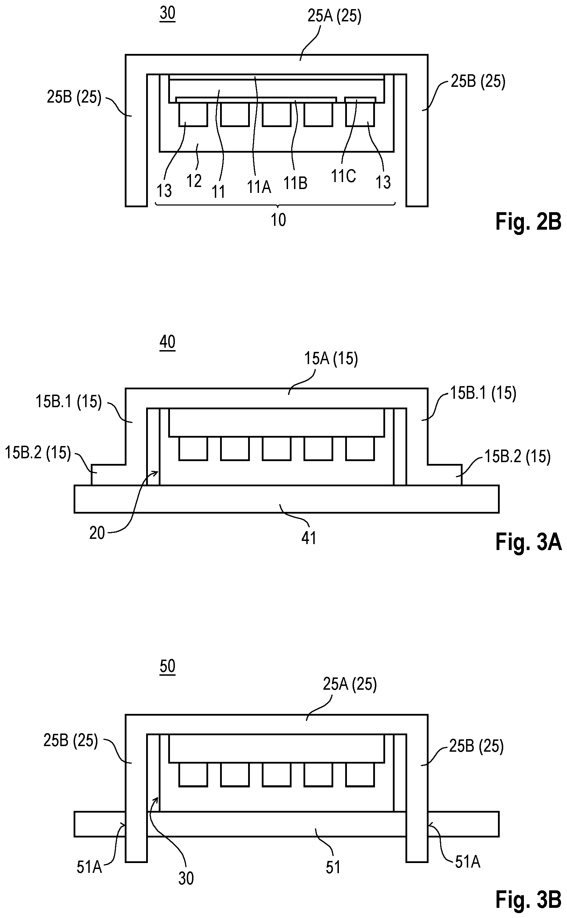

As will be seen in Fig. 2, the electrical contact member 15 is supposed to be connected with the exposed upper contact pad 11A of the semiconductor die 11. In particular, the dimensions of the central portion 15A are preferably so that the horizontal portion 15A will completely cover the contact pad 12A. It may be provided that grooves are formed in the surface at the transitions between the central portion 15A and the side portions 15B in order to facilitate subsequent bending of the side portions.

Fig. 2 comprises Fig. 2A and 2B and shows a semiconductor device package to be mounted by surface mounting technique (A) and a semiconductor package to be mounted by trough-hole technique.

The semiconductor device package 20 shown in Fig. 2A, comprises a semiconductor package 10 such as that shown and described in Fig. 1A. The semiconductor package 10 comprises a semiconductor die 11 comprising a first upper main face and a second lower main face opposite to the first main face. The semiconductor die 11 further comprises a drain pad 11A disposed on the first main face, a source pad 11B and a gate pad 11C, both disposed on the second main face. The semiconductor package 10 further comprises an encapsulant 12, wherein the semiconductor die is embedded in the encapsulant so that the source pad 12B and a gate pad 12C are both covered by the encapsulant 12. The source pad is connected with a plurality of electrical connectors 13 and the gate pad is connected with one electrical connector 13. There can also be a source/sense pad which is also connected with one electrical connector 13. The electrical connectors 13 are connected with the pins 14 which were shown in Fig. 1A. The encapsulant 12 comprises a first lower main face and a second upper main face. The drain pad 11A is exposed by the encapsulant 12 on the second upper main face.

An electrical contact member 15 such as that shown in Fig. 1B is connected to the semiconductor package 10. In particular, the electrical contact member 15 comprises a first horizontal portion 15A and side portions 15B, wherein the side portions 15B are connected to opposite side edges of the first horizontal portion 15A. The first horizontal portion 15A is connected with the second main face of the encapsulant 12 and thus with the exposed drain pad 11A of the semiconductor die 11. The side portions 15B extend along first opposing side faces of the encapsulant 12. The side portions 15B of the electrical contact member 15 each comprise a vertical portion 15B.1 connected with the first horizontal portion 15A and second horizontal portions 15B.2 connected with the vertical portions 15B.1, wherein outer surfaces of the second horizontal portions 15B.2 are coplanar with the first main face of the encapsulant 12.

The semiconductor device package 20 is thus configured to be used as a surface mount device (SMD) which will be seen later in connection with Fig. 3.

The semiconductor device package 30 shown in Fig. 2B, is similar to the semiconductor device package 20 of Fig. 2A and differs from that only with respect to the structure of the electrical contact member 25, in particular the side portions 25B. The electrical contact member 25 comprises a first horizontal portion 25A and side portions 25B, wherein the side portions 25B are connected to opposite side edges of the first horizontal portion 25A. The first horizontal portion 25A is connected with the second main face of the encapsulant 12 and thus with the exposed drain pad 11A of the semiconductor die 11. The side portions 25B extend along first opposing side faces of the encapsulant 12. The side portions 25B of the electrical contact member 25 each comprise a vertical portion 25B connected with the horizontal portion 25A wherein the vertical portions 25B extend beyond the first main face of the encapsulant 12.

The semiconductor device package is thus configured to be used as a through-hole device (TMD) which will be seen later in connection with Fig. 3.

An important feature of the semiconductor device packages 20 and 30 is that the electrical connector 15 or 25 has both an electrical function in the form of electrical contacting of the semiconductor die 12 and also dissipates the excessive heat generated during operation downwards via the PCB or, alternatively, upwards via a heat sink applied to the upper surface of the horizontal section.

Another important feature of the semiconductor device packages 20 and 30 is that the external conductors 14 and 15B or 25B are orthogonal to each other. While the external conductors 15B and 25B, as shown in Figs. 2A and 2B, run transversely, the external pins 14 contacted with the electrical connectors 13 are oriented perpendicular to the image plane. This results in a multiplication of the contacts between the electrical connectors 15 and 25 and the PCB and thus, in addition to the improved heat dissipation, a considerable improvement in the electrical performance, in particular a higher Imax value and a reduced Ron value.

Fig. 3 comprises Fig. 3A and 3B and shows the semiconductor package of Fig. 2A mounted on a substrate (A) and the semiconductor package of Fig. 2B mounted on a substrate (B) .

Fig. 3A shows a semiconductor module 40 comprising a substrate 41 and a semiconductor device package 20 such as that shown in Fig. 2A. The substrate 41 comprises electrical contact areas, wherein the second horizontal portions 15B of the electrical contact member 15 of the semiconductor device package 20 are electrically connected with the electrical contact areas of the substrate 41. The connection of these elements can be carried out using a solder reflow process. It may be provided that the semiconductor device package 20 is first applied to the substrate 41 and then the electrical connector 15 is applied to the package 20 and connected with the electrical contact areas of the substrate 41. A simultaneous reflow soldering process can then be used to connect the electrical connector 15 to the package 20 and with the electrical contact areas. The substrate 41 can be a printed circuit board (PCB). Alternatively, the electrical connector 15 can also be glued to the package 20. This can then also be done before connecting it to the substrate 41, so that in this case the electrical connector 15 with the package 20 attached to it is connected to the substrate 41.

Fig. 3B shows a semiconductor module 50 comprising a substrate 51 and a semiconductor device package 30 such as that shown in Fig. 2B. The substrate 51 comprises through-holes, wherein lower ends of the vertical portions 25B of the electrical contact member are inserted through these through-holes and connected to them using a soldering process. It may be provided that the semiconductor device package 30 is first applied to the substrate 51 and then the electrical connector 25 is applied to the package 30 and inserted through the through holes. A simultaneous reflow soldering process can then be used to connect the electrical connector 25 to the package 30 in the same way as to the through holes. Wave soldering, for example, can be used to connect to the through holes. Alternatively, the electrical connector 25 can also be glued to the package 30. This can then also be done before connecting it to the substrate 51, so that in this case the electrical connector 15 with the package 30 attached to it is connected to the substrate 51.

The substrate 41 or 51 may comprise a printed circuit board (PCB).

The semiconductor module 40 or 50 may further comprise a heatsink mounted onto the surface of the first horizontal portion 15A or 25A of the electrical contact member 15 or 25 of the semiconductor package 10 or 20.

### EXAMPLES

In the following specific examples of the present disclosure are described.

Example 1 is a semiconductor package comprising a semiconductor transistor die comprising a first main face, a second main face opposite to the first main face, a first contact pad disposed on the first main face, and a second contact pad disposed on the second main face, an encapsulant embedding the semiconductor transistor die, the encapsulant comprises a first main face and a second main face opposite to the first main face, wherein the second main face of the encapsulant is coplanar with the second main face of the semiconductor transistor die, and an electrical contact member connected with the encapsulant, the electrical contact member comprising a first horizontal portion and side portions connected to opposite side edges of the first horizontal portion, wherein the first horizontal portion is connected with the second main face of the encapsulant, and wherein the side portions extend along first opposing side faces of the encapsulant and are configured as first electrical contact elements.

Example 2 is a semiconductor package according to Example 1, wherein the side portions of the electrical contact member each comprise a vertical portion connected with the first horizontal portion and second horizontal portions connected with the vertical portions, wherein outer surfaces of the second horizontal portions are coplanar with the first main face of the encapsulant.

Example 3 is a semiconductor package according to Example 1, wherein the side portions of the electrical contact member each comprise a vertical portion connected with the horizontal portion wherein the vertical portions extend beyond the first main face of the encapsulant.

Example 4 is a semiconductor package according to any one of the preceding Examples, wherein one or more side portions are connected to the opposite side edges of the first horizontal portion.

Example 5 is a semiconductor package according to any one of the preceding Examples, further comprising second electrical contact elements connected with the first contact pad of the semiconductor transistor die.

Example 6 is a semiconductor package according to Example 5, wherein the second electrical contact elements are partly embedded within the encapsulant and extend through at least one second side face of the encapsulant which is oriented perpendicular to the first side faces of the encapsulant.

Example 7 is a semiconductor package according to Example 6, wherein the second electrical contact elements extend through two opposing side faces which are both perpendicular to the first opposing side faces of the encapsulant.

Example 8 is a semiconductor package according to any one of the preceding Examples, wherein the semiconductor transistor die comprises one or more of a vertical semiconductor transistor die, a semiconductor power transistor die, an IGBT die, a MOSFET die, a CoolMOS die, a wide band gap semiconductor transistor die, in particular a SiC transistor die or a GaN transistor die.

Example 9 is a semiconductor package according to any one of the preceding Examples, wherein the first contact pad of the semiconductor transistor die is a source/emitter contact pad and the second contact pad is drain/collector contact pad.

Example 10 is a semiconductor package according to any one of the preceding Examples, wherein the horizontal portion of the electrical contact member is connected to the second main face of the encapsulant by means of a solder layer, a sinter layer, or an adhesive layer.

Example 11 is a semiconductor module, comprising a substrate, and a semiconductor package according to any one of the preceding claims mounted on the substrate).

Example 12 is a semiconductor module according to Example 7 in connection with Example 2 or any one of Examples 3 to 6 related back to Example 2, wherein the substrate comprises electrical contact areas, wherein the second horizontal portions of the electrical contact member are connected with the electrical contact areas of the substrate.

Example 13 is a semiconductor module according to Example 7 in connection with Example 3 or any one of Example 4 to 6 related back to Example 3, wherein the substrate comprises through-holes, wherein lower ends of the vertical portions of the electrical contact member are put through the through holes of the substrate.

Example 14 is a semiconductor module according to any one of Examples 11 to 13, wherein the substrate comprises a printed circuit board.

Example 15 is a semiconductor module according to any one of Examples 11 to 14, further comprising a heatsink mounted onto the surface of the first horizontal portion of the electrical contact member of the semiconductor package.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A semiconductor package (20; 30) comprising
- a semiconductor transistor die (11) comprising a first main face, a second main face opposite to the first main face, a first contact pad (11B) disposed on the first main face, and a second contact pad (11A) disposed on the second main face;
- an encapsulant (12) embedding the semiconductor transistor die, the encapsulant (12) comprises a first main face and a second main face opposite to the first main face, wherein the second main face of the encapsulant (12) is coplanar with the second main face of the semiconductor transistor die (11); and
- an electrical contact member (15; 25) connected with the encapsulant (12), the electrical contact member (15; 25) comprising a first horizontal portion (15A; 25A) and side portions (15B; 25B) connected to opposite side edges of the first horizontal portion (15A; 25A), wherein the first horizontal portion (15A; 25A) is connected with the second main face of the encapsulant (12); and wherein the side portions (15B; 25B) extend along first opposing side faces of the encapsulant (12) and are configured as first electrical contact elements.

2. The semiconductor package (20) according to claim 1, wherein
the side portions (15B) of the electrical contact member (15) each comprise a vertical portion (15B.1) connected with the first horizontal portion (15A) and second horizontal portions (15B.2) connected with the vertical portions (15B.1), wherein outer surfaces of the second horizontal portions (15B.2) are coplanar with the first main face of the encapsulant (12).

3. The semiconductor package (30) according to claim 1, wherein
the side portions (25B) of the electrical contact member (25) each comprise a vertical portion connected with the horizontal portion (25A) wherein the vertical portions extend beyond the first main face of the encapsulant (12).

4. The semiconductor package (20; 30) according to any one of the preceding claims, wherein
one or more side portions (15B; 25B) are connected to the opposite side edges of the first horizontal portion (15A; 25A).

5. The semiconductor package (20; 30) according to any one of the preceding claims, further comprising
second electrical contact elements (14) connected with the first contact pad of the semiconductor transistor die (11).

6. The semiconductor package (20; 30) according to claim 5, wherein
the second electrical contact elements (14) are partly embedded within the encapsulant (12) and extend through at least one second side face of the encapsulant (12) which is oriented perpendicular to the first side faces of the encapsulant (12) .

7. The semiconductor package (20; 30) according to claim 6, wherein
the second electrical contact elements (14) extend through two opposing side faces which are both perpendicular to the first opposing side faces of the encapsulant (12).

8. The semiconductor package (20; 30) according to any one of the preceding claims, wherein
the semiconductor transistor die (11) comprises one or more of a vertical semiconductor transistor die, a semiconductor power transistor die, an IGBT die, a MOSFET die, a CoolMOS die, a wide band gap semiconductor transistor die, in particular a SiC transistor die or a GaN transistor die.

9. The semiconductor package (20; 30) according to any one of the preceding claims, wherein
the first contact pad of the semiconductor transistor die (11) is a source/emitter contact pad and the second contact pad is drain/collector contact pad.

10. The semiconductor package (20; 30) according to any one of the preceding claims, wherein
the horizontal portion (15A; 25A) of the electrical contact member (15) is connected to the second main face of the encapsulant (12) by means of a solder layer, a sinter layer, or an adhesive layer.

11. A semiconductor module (40; 50), comprising
a substrate (41; 51), and
a semiconductor package (20; 30) according to any one of the preceding claims mounted on the substrate (41; 51).

12. The semiconductor module (40) according to claim 7 in connection with claim 2 or any one of claims 3 to 6 related back to claim 2, wherein
the substrate (41) comprises electrical contact areas, wherein
the second horizontal portions (15B) of the electrical contact member (15) are connected with the electrical contact areas of the substrate (41).

13. The semiconductor module (50) according to claim 7 in connection with claim 3 or any one of claims 4 to 6 related back to claim 3, wherein
the substrate (51) comprises through-holes, wherein
lower ends of the vertical portions (25B) of the electrical contact member (25) are put through the through holes of the substrate (51).

14. The semiconductor module (40; 50) according to any one of claims 11 to 13, wherein
the substrate (41; 51) comprises a printed circuit board.

15. The semiconductor module (40; 50) according to any one of claims 11 to 14, further comprising
a heatsink mounted onto the surface of the first horizontal portion (15A; 25A) of the electrical contact member (15; 25) of the semiconductor package (20; 30).
